# EUROPEAN PATENT APPLICATION

(11) **EP 4 682 945 A1**
(43) Date of publication of application: **21.01.2026**
(21) Application number: 24769808.7
(22) Date of filing: 06.03.2024
(51) Int. Cl.: H01L 21/67

(54) **EXHAUST DISCHARGE APPARATUS AND SEMICONDUCTOR THERMAL TREATMENT DEVICE**

(30) Priority: 15.03.2023 CN 202310269649
(71) Applicant: Beijing NAURA Microelectronics Equipment Co., Ltd., Beijing 100176 (CN)
(72) Inventor: WANG, Lika, Beijing 100176 (CN); GUANG, Yaohua, Beijing 100176 (CN); SHI, Lei, Beijing 100176 (CN)
(74) Representative: Cohausz & Florack
(86) International application number: PCT/CN2024/080213
(87) International publication number: WO 2024/188114

(57) **Abstract**

The present disclosure provides an exhaust discharge apparatus and a semiconductor thermal treatment equipment, and relates to the field of semiconductor technology. The exhaust discharge apparatus includes a discharging gas path, an oxygen detection gas path, and a purging gas path, and the discharging gas path is configured to discharge exhaust; the oxygen detection gas path is communicated in parallel with the discharging gas path, a gas inlet end of the oxygen detection gas path is communicated with a first position of the discharging gas path, a gas outlet end of the oxygen detection gas path is communicated with a second position of the discharging gas path, and the second position is downstream of the first position; and a gas outlet end of the purging gas path is communicated with an entrance section of a gas inlet path of the oxygen detection gas path. The semiconductor thermal treatment equipment includes a reaction chamber and the exhaust discharge apparatus, and the exhaust discharge apparatus is connected to the reaction chamber. The exhaust discharge apparatus can strictly control an oxygen content in the reaction chamber and ensure normal use of the oxygen detection gas path, thereby ensuring an annealing effect of the semiconductor thermal treatment equipment on a wafer and processing quality of the wafer by the semiconductor thermal treatment equipment.

## Description

### TECHNICAL FIELD

The present disclosure relates to, but is not limited to, the field of semiconductor technology, and particularly relates to an exhaust discharge apparatus and a semiconductor thermal treatment equipment.

### BACKGROUND

In the field of manufacturing of integrated circuits, a vertical furnace is used to perform an annealing process to remove crystal structure stress inside a wafer, so that the vertical furnace has been widely applied to a semiconductor thermal treatment equipment as a front-end process device. During the annealing process, quality of a thin film on a surface of the wafer may be damaged when oxygen content is too high in a reaction chamber. However, in the related art, the oxygen content in the reaction chamber cannot be strictly controlled when the vertical furnace operates, resulting in a poor annealing effect of the vertical furnace on the wafer and poor processing quality of the wafer by the vertical furnace.

### SUMMARY

The present disclosure at least aims to provide an exhaust discharge apparatus and a semiconductor thermal treatment equipment, so as to solve the technical problem that the annealing effect of the semiconductor thermal treatment equipment on the wafer and the processing quality of the wafer by the semiconductor thermal treatment equipment are poor at present because the oxygen content in the reaction chamber of the semiconductor thermal treatment equipment cannot be strictly controlled when the semiconductor thermal treatment equipment operates.

In order to solve the above technical problem, the present disclosure provides an exhaust discharge apparatus of a semiconductor thermal treatment equipment, including:
a discharging gas path, which is configured to discharge exhaust;
an oxygen detection gas path, which is communicated in parallel with the discharging gas path, wherein a gas inlet end of the oxygen detection gas path is communicated with a first position of the discharging gas path, a gas outlet end of the oxygen detection gas path is communicated with a second position of the discharging gas path, and the second position is downstream of the first position; and
a purging gas path, which has a gas outlet end communicated with an entrance section of a gas inlet path of the oxygen detection gas path.

In some embodiments, a gas inlet end of the entrance section extends into the discharging gas path, and an orientation of a port of the gas inlet end of the entrance section is the same as a flow direction of the discharging gas path at the first position.

In some embodiments, the oxygen detection gas path includes an oxygen analyzer, a gas inlet of the oxygen analyzer is communicated with the first position through an oxygen-detection gas inlet pipe used as the gas inlet path, and a gas outlet of the oxygen analyzer is communicated with the second position through an oxygen-detection gas outlet pipe; and the oxygen-detection gas inlet pipe is provided with an oxygen sampling on-off valve.

In some embodiments, the oxygen sampling on-off valve is a normally closed pneumatic valve.

In some embodiments, the purging gas path includes a purging pipe, and a purging pressure control valve, a purging pressure gauge, a purging throttle valve, and a purging on-off valve are sequentially disposed on the purging pipe along a purging direction.

In some embodiments, the purging on-off valve is a normally open pneumatic valve.

In some embodiments, the purging pipe is further provided with a first hand operated valve, which is upstream of the purging pressure control valve.

In some embodiments, the exhaust discharge apparatus further includes a supplementing gas path, and a gas outlet end of the supplementing gas path is communicated with the gas inlet of the oxygen analyzer.

In some embodiments, the supplementing gas path includes a supplementing pipe, a gas inlet end of the supplementing pipe is communicated with the purging gas path, and a gas outlet end of the supplementing pipe is communicated with the gas inlet of the oxygen analyzer; and the supplementing pipe is provided with a supplementing throttle valve and a supplementing on-off valve.

In some embodiments, the supplementing on-off valve is a normally open pneumatic valve.

In some embodiments, the exhaust discharge apparatus further includes a first hydrogen detection gas path and a hydrogen dilution gas path, a gas inlet end of the first hydrogen detection gas path is communicated with a third position of the discharging gas path, a gas outlet end of the first hydrogen detection gas path is communicated with a fourth position of the discharging gas path, and the third position is upstream of the fourth position and the second position; and
a gas outlet end of the hydrogen dilution gas path is communicated with a fifth position of the discharging gas path, and the fifth position is upstream of the third position.

In some embodiments, the first hydrogen detection gas path includes a first hydrogen detector, a gas inlet of the first hydrogen detector is communicated with the third position through a first hydrogen-detection gas inlet pipe, a gas outlet of the first hydrogen detector is communicated with the fourth position through a first hydrogen-detection gas outlet pipe, and the first hydrogen-detection gas inlet pipe is provided with a first hydrogen sampling on-off valve and a first hydrogen sampling throttle valve; and
the gas inlet of the first hydrogen detector is further communicated with a first air delivery pipe, and the first air delivery pipe is provided with a first air delivery throttle valve and a first air delivery on-off valve.

In some embodiments, a first end of the first hydrogen-detection gas outlet pipe is connected to the gas outlet of the first hydrogen detector, and a second end of the first hydrogen-detection gas outlet pipe is connected to a gas outlet path of the oxygen detection gas path, and is communicated with the discharging gas path through the gas outlet path.

In some embodiments, the hydrogen dilution gas path includes a dilution pipe, and a gas outlet end of the dilution pipe is communicated with the fifth position; and a dilution pressure control valve, a dilution pressure gauge, a dilution flowmeter, and a dilution on-off valve are sequentially disposed on the dilution pipe along a gas delivery direction.

In some embodiments, the dilution on-off valve is a normally open pneumatic valve.

In some embodiments, the dilution pipe is further provided with a second hand operated valve, which is upstream of the dilution pressure control valve.

In some embodiments, the exhaust discharge apparatus further includes a second hydrogen detection gas path, a gas inlet end of the second hydrogen detection gas path is communicated with a sixth position of the discharging gas path, a gas outlet end of the second hydrogen detection gas path is communicated with a seventh position of the discharging gas path, and the sixth position is upstream of the seventh position and the second position.

In some embodiments, the discharging gas path includes an exhaust pipe, a cooling assembly and a pressure control valve are sequentially disposed on the exhaust pipe along a flow direction of the exhaust pipe, the first position is upstream of the cooling assembly, and the second position is downstream of the pressure control valve.

The present disclosure further provides a semiconductor thermal treatment equipment, including a reaction chamber and the above exhaust discharge apparatus, and the exhaust discharge apparatus is connected to the reaction chamber.

In the exhaust discharge apparatus provided in the present disclosure, the oxygen detection gas path can achieve detection and feedback of an oxygen concentration in the reaction chamber by detecting an oxygen concentration of the exhaust in the discharging gas path in real time, the oxygen concentration in the reaction chamber is continuously reduced with introduction of a protective gas, and when the oxygen concentration of the exhaust fed back by the oxygen detection gas path is lower than a set concentration value, which indicates that an oxygen content in the reaction chamber meets a standard, the introduction of the protective gas into the reaction chamber is stopped, the oxygen detection gas path is closed, and a subsequent annealing process is performed. In this way, the deterioration of the quality of the thin film on the surface of the wafer caused by the over-high oxygen content in the reaction chamber can be reduced, and the annealing effect of the semiconductor thermal treatment equipment on the wafer and the processing quality of the wafer by the semiconductor thermal treatment equipment can be accordingly ensured. In addition, in a cleaning processing, since the purging gas path continuously blows a purge gas into the discharging gas path through the entrance section, the exhaust in the discharging gas path cannot flow into the entrance section, and accordingly, the exhaust in the discharging gas path cannot flow into the oxygen detection gas path, so that a protection effect on the oxygen detection gas path is ensured in the cleaning process, corrosion damage to pipes and components of the oxygen detection gas path by a cleaning gas entering the oxygen detection gas path is reduced, normal and accurate use of the oxygen detection gas path is accordingly ensured, and the annealing effect of the semiconductor thermal treatment equipment on the wafer and the processing quality of the wafer by the semiconductor thermal treatment equipment are further ensured.

### BRIEF DESCRIPTION OF DRAWINGS

In order to illustrate the technical solutions in the embodiments of the present disclosure or in the existing technology more clearly, drawings for the illustration of the embodiments or the existing technology will be briefly described below. Apparently, the drawings described below are only for some embodiments of the present disclosure, and other drawings can be derived by those of ordinary skill in the art from the drawings described below without any inventive work.
FIG. 1 is flowchart illustrating a case where an exhaust discharge apparatus in a semiconductor thermal treatment equipment takes a first form according to the present disclosure;
FIG. 2 is flowchart illustrating a case where an exhaust discharge apparatus in a semiconductor thermal treatment equipment takes a second form according to the present disclosure;
FIG. 3 is flowchart illustrating a case where an exhaust discharge apparatus in a semiconductor thermal treatment equipment takes a third form according to the present disclosure;
FIG. 4 is flowchart illustrating a case where an exhaust discharge apparatus in a semiconductor thermal treatment equipment takes a fourth form according to the present disclosure; and
FIG. 5 is flowchart illustrating a case where an exhaust discharge apparatus in a semiconductor thermal treatment equipment takes a fifth form according to the present disclosure.

### Description of reference numerals:

10-reaction chamber; 12-exhaust joint; 13-first position; 14-second position; 15-third position; 16-fourth position; 17-fifth position; 18-sixth position; 19-seventh position; 100-discharging gas path; 110-exhaust pipe; 120-cooling assembly; 130-discharging pressure control valve; 200-oxygen detection gas path; 210-oxygen-detection gas inlet pipe; 211-entrance section; 220-oxygen analyzer; 230-oxygen-detection gas outlet pipe; 240-oxygen sampling on-off valve; 300-purging gas path; 310-purging pipe; 320-purging pressure control valve; 330-purging pressure gauge; 340-purging throttle valve; 350-purging on-off valve; 360-first hand operated valve; 400-supplementing gas path; 410-supplementing pipe; 420-supplementing throttle valve; 430-supplementing on-off valve; 500-first hydrogen detection gas path; 510-first hydrogen-detection gas inlet pipe; 520-first hydrogen detector; 530-first hydrogen-detection gas outlet pipe; 540-first hydrogen sampling on-off valve; 550-first hydrogen sampling throttle valve; 560-first air delivery pipe; 570-first air delivery throttle valve; 580-first air delivery on-off valve; 600-hydrogen dilution gas path; 610-dilution pipe; 620-dilution pressure control valve; 630-dilution pressure gauge; 640-dilution flowmeter; 650-dilution on-off valve; 660-second hand operated valve; 700-second hydrogen detection gas path; 710-second hydrogen-detection gas inlet pipe; 720-second hydrogen detector; 730-second hydrogen-detection gas outlet pipe; 740-second hydrogen sampling on-off valve; 750-second hydrogen sampling throttle valve; 760-second air delivery pipe; 770-second air delivery throttle valve; 780-second air delivery on-off valve.

### DETAIL DESCRIPTION OF EMBODIMENTS

In order to make the above objectives, features and advantages of the present disclosure more obvious and understandable, specific embodiments of the present disclosure are described in detail below with reference to the drawings. It should be understood that the specific embodiments described herein are only intended to explain the present disclosure, rather than limiting the present disclosure.

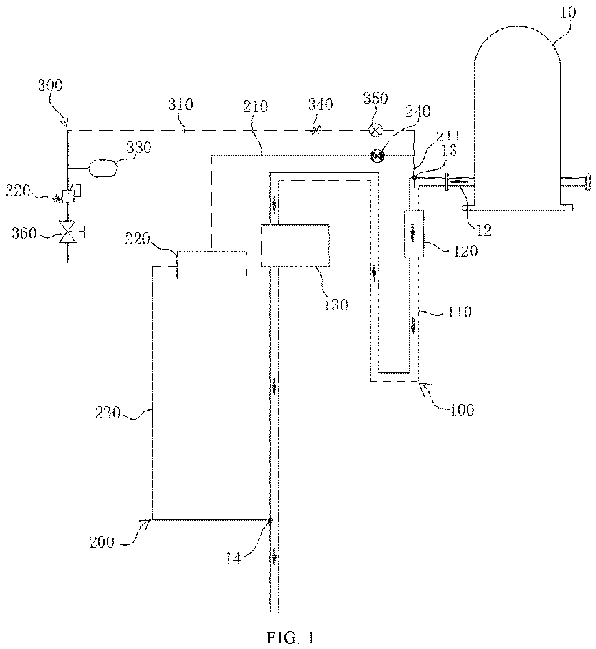

An embodiment of the present disclosure provides an exhaust discharge apparatus of a semiconductor thermal treatment equipment. As shown in FIG. 1, the exhaust discharge apparatus includes a discharging gas path 100, an oxygen detection gas path 200, and a purging gas path 300. The discharging gas path 100 is configured to discharge exhaust; the oxygen detection gas path 200 is communicated in parallel with the discharging gas path 100, a gas inlet end of the oxygen detection gas path 200 is communicated with a first position 13 of the discharging gas path 100, a gas outlet end of the oxygen detection gas path 200 is communicated with a second position 14 of the discharging gas path 100, and the second position 14 is downstream of the first position 13; and the oxygen detection gas path 200 is provided with a gas inlet path, and a gas outlet end of the purging gas path 300 is communicated with an entrance section 211 of the gas inlet path of the oxygen detection gas path 200.

The present embodiment further provides a semiconductor thermal treatment equipment, which, as shown in FIG. 1, includes a reaction chamber 10 and the above exhaust discharge apparatus, and the exhaust discharge apparatus is connected to the reaction chamber 10 for discharging exhaust from the reaction chamber 10.

As for the exhaust discharge apparatus and the semiconductor thermal treatment equipment provided in the present embodiment, the exhaust discharge apparatus includes the discharging gas path 100 for discharging the exhaust from the reaction chamber 10, the oxygen detection gas path 200 for detecting an oxygen concentration of the exhaust in the discharging gas path 100, and the purging gas path 300 for purging the entrance section 211 of the gas inlet path of the oxygen detection gas path 200; and the semiconductor thermal treatment equipment includes the reaction chamber 10 for performing an annealing process on a wafer, and the discharging gas path 100 for discharging the exhaust.

When the semiconductor thermal treatment equipment is in use, a wafer to be annealed is placed in the reaction chamber 10, and an inert atmosphere preparation process is first performed. Specifically, a gas inlet end of the purging gas path 300 is connected to a purge gas source of a plant system and is in an off state, the oxygen detection gas path 200 is in an operating state, and a protective gas source introduces a protective gas such as argon into the reaction chamber 10, so as to expel oxygen from the reaction chamber 10, and prepare an inert atmosphere for the annealing of the wafer; the exhaust in the reaction chamber 10 flows into the discharging gas path 100, part of the exhaust in the discharging gas path 100 may flow into the oxygen detection gas path 200 through a communicated position between the first position 13 of the discharging gas path 100 and the oxygen detection gas path 200, flow back into the discharging gas path 100 through a communicated position between the second position 14 of the discharging gas path 100 and the oxygen detection gas path 200 after being subjected to oxygen concentration detection in the oxygen detection gas path 200, and finally be discharged to the plant system. The oxygen detection gas path 200 may achieve detection and feedback of the oxygen concentration in the reaction chamber 10 by detecting the oxygen concentration of the exhaust in the discharging gas path 100 in real time, the oxygen concentration in the reaction chamber 10 is continuously reduced with the introduction of the protective gas, and when the oxygen concentration of the exhaust fed back by the oxygen detection gas path 200 is lower than a set concentration value, which indicates that an oxygen content in the reaction chamber 10 meets a standard, the introduction of the protective gas into the reaction chamber 10 is stopped, the oxygen detection gas path 200 is closed, and the subsequent annealing process is performed. In this way, the deterioration of the quality of the thin film on the surface of the wafer caused by the over-high oxygen content in the reaction chamber 10 can be reduced, and an annealing effect of the semiconductor thermal treatment equipment on the wafer and processing quality of the wafer by the semiconductor thermal treatment equipment can be accordingly ensured.

When the semiconductor thermal treatment equipment needs to be subjected to a cleaning process after being used for a period of time, the purging gas path 300 is controlled to be in an operating state, the oxygen detection gas path 200 is kept in an off state, the entrance section 211 of the gas inlet path of the oxygen detection gas path 200 always function to allow a gas to pass through, the purging gas path 300 blows a purge gas into the entrance section 211, and the purge gas is blown into the discharging gas path 100 through a communicated end between the entrance section 211 and the discharging gas path 100; a cleaning gas source introduces a cleaning gas into the reaction chamber 10, and the exhaust containing the cleaning gas flows into the discharging gas path 100, and is then discharged to the plant system. Since the purging gas path 300 continuously blows the purge gas into the discharging gas path 100 through the entrance section 211, the exhaust in the discharging gas path 100 cannot flow into the entrance section 211, and accordingly, the exhaust in the discharging gas path 100 cannot flow into the oxygen detection gas path 200, so that a protection effect on the oxygen detection gas path 200 is ensured during the cleaning process, corrosion damage to pipes and components of the oxygen detection gas path 200 by the cleaning gas entering the oxygen detection gas path 200 is reduced, normal and accurate use of the oxygen detection gas path 200 is accordingly ensured, and the annealing effect of the semiconductor thermal treatment equipment on the wafer and the processing quality of the wafer by the semiconductor thermal treatment equipment are further ensured.

Specifically, the semiconductor thermal treatment equipment may be a vertical furnace, the reaction chamber 10 of the vertical furnace may be provided with an exhaust joint 12, and a gas inlet end of the discharging gas path 100 is connected to the exhaust joint 12 to be communicated with the reaction chamber 10; the set concentration value of oxygen may be 3 ppm; and the cleaning gas may be hydrogen chloride, and specifically, a pipeline of the discharging gas path 100 may be made of a corrosion-resistant material such as quartz tubes.

In some embodiments, as shown in FIG. 1, a gas inlet end of the entrance section 211 extends into the discharging gas path 100, and an orientation of a port of the gas inlet end of the entrance section 211 is the same as a flow direction of the discharging gas path 100 at the first position 13. During the cleaning process, since the orientation of the port of the gas inlet end of the entrance section 211 is the same as the flow direction of the discharging gas path 100 at the corresponding position, a flow direction of the purge gas blown from the purging gas path 300 into the discharging gas path 100 through the gas inlet end of the entrance section 211 is approximately the same as a flow direction of the exhaust in the discharging gas path 100 at this position, so that the purge gas may be rapidly and stably mixed with the exhaust in the discharging gas path 100, and flow downstream along with the exhaust, which reduces the occurrence of the purge gas and the exhaust colliding and generating vortices to affect normal discharging of the exhaust by the discharging gas path 100 due to the flow direction of the purge gas and the flow direction of the exhaust in the discharging gas path 100 intersecting with each other or even being opposite to each other at the communicated position.

The entrance section 211 is a section of the gas inlet path of the oxygen detection gas path 200 close to the gas inlet end, and under the above conditions, the gas inlet end (also serving as the gas outlet end for the purge gas) of the entrance section 211 extends into the discharging gas path 100, the purging gas path 300 is communicated with a portion of the entrance section 211 located outside the discharging gas path 100, that is, one portion of the entrance section 211 is located outside the discharging gas path 100, the other portion of the entrance section 211 is located inside the discharging gas path 100, and the oxygen detection gas path 200 and the purging gas path 300 share the portion of the entrance section 211 located outside the discharging gas path 100. Certainly, in addition to the way in which the purging gas path 300 is communicated with the portion of the entrance section 211 located outside the discharging gas path 100, the purging gas path 300 may share the port of the gas inlet end of the entrance section 211 so as to be communicated with the entrance section 211, so that the purge gas may be blown out through the port, thereby gas-sealing the port to achieve the protection for the oxygen detection gas path 200.

Specifically, in the present embodiment, as shown in FIG. 1, the oxygen detection gas path 200 includes an oxygen analyzer 220, a gas inlet of the oxygen analyzer 220 is communicated with the first position 13 through an oxygen-detection gas inlet pipe 210, a gas outlet of the oxygen analyzer 220 is communicated with the second position 14 through an oxygen-detection gas outlet pipe 230; and the oxygen-detection gas inlet pipe 210 is provided with an oxygen sampling on-off valve 240. What is described here is one of the specific forms of the oxygen detection gas path 200. The oxygen-detection gas inlet pipe 210 serves as the gas inlet path, the oxygen analyzer 220 is used for oxygen concentration detection, the oxygen-detection gas outlet pipe 230 serves as a gas outlet path, and the oxygen sampling on-off valve 240 is configured to control on and off of the oxygen-detection gas inlet pipe 210; and in the inert atmosphere preparation process, the oxygen analyzer 220 is turned on, the oxygen sampling on-off valve 240 is opened to enable the oxygen-detection gas inlet pipe 210 to be in a communicated state, the oxygen detection gas path 200 is in an operating state, the oxygen analyzer 220 sucks oxygen to cause a negative pressure state inside the oxygen-detection gas inlet pipe 210, so that the exhaust in the discharging gas path 100 flows into the oxygen-detection gas inlet pipe 210 through the communicated position at the first position 13 under the action of pressure difference, and then flows into the oxygen analyzer 220 through the gas inlet, and then the exhaust flows into the oxygen-detection gas outlet pipe 230 through a gas outlet of the oxygen analyzer 220 after being subjected to oxygen concentration analysis and feedback by the oxygen analyzer 220, further flows back into the discharging gas path 100 through the second position 14, and is finally discharged to the plant system, thereby completing the detection and feedback of the oxygen concentration of the exhaust in the reaction chamber 10.

Certainly, the oxygen detection gas path 200 may adopt other forms as long as the oxygen detection gas path 200 can achieve the detection of the oxygen concentration of the exhaust, and the oxygen detection gas path 200 is not limited to the above form.

In the present embodiment, the oxygen sampling on-off valve 240 may be a normally closed pneumatic valve. When the oxygen sampling on-off valve 240 operates normally, the oxygen sampling on-off valve 240 may be at a communicating position or a blocking position by controlling on and off thereof, so as to correspondingly control on and off of the oxygen-detection gas inlet pipe 210; and when the oxygen sampling on-off valve 240 fails, the oxygen sampling on-off valve 240 may remain normally closed to block the oxygen-detection gas inlet pipe 210 and enable the oxygen-detection gas inlet pipe 210 to be in a non-communicated state, so that the occurrence of damaging the pipeline and the oxygen analyzer 220 by a corrosive cleaning gas when entering the oxygen detection gas path 200 during the failure is reduced, the oxygen analyzer 220 is accordingly protected, accuracy of use of the oxygen analyzer 220 is ensured, and service life of the oxygen analyzer 220 is prolonged.

In some embodiments, as shown in FIG. 1, the purging gas path 300 includes a purging pipe 310, and a purging pressure control valve 320, a purging pressure gauge 330, a purging throttle valve 340, and a purging on-off valve 350 are sequentially disposed on the purging pipe 310 along a purging direction. In an example, the purging pressure control valve 320 and the purging pressure gauge 330 are located in an upstream section of the purging pipe 310 (i.e., a section close to a gas inlet end of the purging pipe 310), and the purging throttle valve 340 and the purging on-off valve 350 are located in a downstream section of the purging pipe 310 (i.e., a section close to a gas outlet end of the purging pipe 310). What is described here is one of the specific forms of the purging gas path 300. The gas inlet end of the purging pipe 310 is connected to the purge gas source of the plant system, the purging pressure control valve 320 is configured to adjust a pressure of the purge gas introduced by the purge gas source into the purging pipe 310, the purging pressure gauge 330 is configured to display a purge pressure in the corresponding section, the purging throttle valve 340 is configured to adjust a flow of the purge gas, and the purging on-off valve 350 is configured to control on and off of the purging pipe 310; when the cleaning process does not need to be performed, the purging on-off valve 350 is closed, and the purging gas path 300 is in an off state; and when the cleaning process needs to be performed, the purging on-off valve 350 is opened, the pressure of the purge gas introduced by the purge gas source is adjusted by the purging pressure control valve 320, and the flow of the purge gas blown into the entrance section 211 is adjusted by the purging throttle valve 340, so as to reduce consumption of the purge gas while blowing the purge gas to the entrance section 211 to achieve the gas-sealing protection for the oxygen detection gas path 200.

Specifically, in the present embodiment, the purging on-off valve 350 may be a normally open pneumatic valve. When the purging on-off valve 350 operates normally, the purging on-off valve 350 may be at a communicating position or a blocking position by controlling on and off thereof, so as to correspondingly control on and off of the purging pipe 310; and when the purging on-off valve 350 fails, the purging on-off valve 350 may remain normally open to enable the purging pipe 310 to be in a communicated state, so that the purge gas source may introduce the purge gas into the entrance section 211 through the purging pipe 310, which ensures a purging effect on the entrance section 211, and accordingly reduces the occurrence of corrosion damage to the oxygen detection gas path 200 by a corrosive cleaning gas which enters the oxygen detection gas path 200 due to a failure of the purging gas path 300 to perform purging.

In the present embodiment, as shown in FIG. 1, the purging pipe 310 is further provided with a first hand operated valve 360, which is upstream of the purging pressure control valve 320. The first hand operated valve 360 is configured to manually control on and off of a most upstream section of the purging pipe 310 to control the introduction of the purge gas by the purge gas source into the purging pipe 310 at the source, and may cooperate with the purging on-off valve 350 for performing a secondary on-off control function. In particular, when the purging on-off valve 350 fails, on and off of the purging pipe 310 may be controlled by the first hand operated valve 360 to ensure normal use of the purging gas path 300, so as to improve stability and functionality of the purging gas path 300.

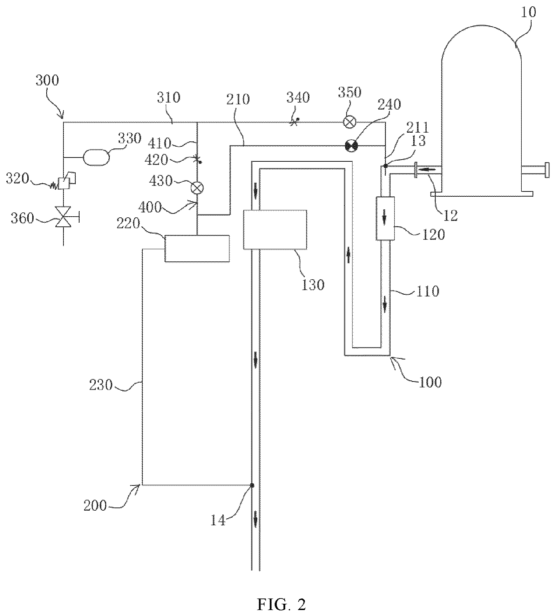

In some embodiments, as shown in FIG. 2, the exhaust discharge apparatus further includes a supplementing gas path 400, and a gas outlet end of the supplementing gas path 400 is communicated with the gas inlet of the oxygen analyzer 220. When the exhaust discharge apparatus operates, a gas inlet end of the supplementing gas path 400 is connected to a supplementing gas source of the plant system, the oxygen detection gas path 200 does not need to detect the oxygen concentration of the exhaust after the inert atmosphere preparation process is completed, the oxygen sampling on-off valve 240 is in a closed state, the supplementing gas path 400 is controlled to be in an operating state, the supplementing gas source may introduce an inert gas into the oxygen analyzer 220 through the supplementing gas path 400 to expel the residual oxygen from the oxygen analyzer 220, so as to ensure that the oxygen analyzer 220 is in an oxygen-free atmosphere, and accordingly ensure accuracy of a next oxygen concentration detection by the oxygen analyzer 220. In addition, when the semiconductor thermal treatment equipment performs the annealing process after the inert atmosphere preparation process, the oxygen analyzer 220 may be in a standby state, and the supplementing gas path 400 continuously conveys the inert gas into the oxygen analyzer 220, so as to reduce adverse effects on the accuracy and the service life of the oxygen analyzer 220 caused by dry pumping, thereby accordingly ensuring normal use of the oxygen analyzer 220 and prolong the service life thereof.

Specifically, in the present embodiment, as shown in FIG. 2, the supplementing gas path 400 includes a supplementing pipe 410, a gas inlet end of the supplementing pipe 410 is communicated with the purging gas path 300, and a gas outlet end of the supplementing pipe 410 is communicated with the gas inlet of the oxygen analyzer 220; the supplementing pipe 410 is provided with a supplementing throttle valve 420 and a supplementing on-off valve 430. What is described here is one of the specific forms of the supplementing gas path 400. The gas inlet end of the supplementing pipe 410 is communicated with the purging gas path 300, then the supplementing gas source for the supplementing gas path 400 and the purge gas source for the purging gas path 300 are the same gas source, that is, the same gas source can simultaneously supply the gas to the purging gas path 300 and the supplementing gas path 400, which improves structural simplicity and functionality of the exhaust discharge apparatus; when the oxygen analyzer 220 needs to be supplemented with the inert gas, the purging gas path 300 is controlled to be in an off state, the supplementing on-off valve 430 is opened, the supplementing pipe 410 is in a communicated state, the supplementing gas source may introduce the inert gas into the purging gas path 300, the inert gas then flows into the supplementing pipe 410 through a communicated position, and a flow of the inert gas flowing to the oxygen analyzer 220 is adjusted by the supplementing throttle valve 420, thereby supplementing the oxygen analyzer 220 with the inert gas and protecting the oxygen analyzer 220; and when the oxygen analyzer 220 needs to analyze the oxygen concentration of the exhaust, the purging gas path 300 is controlled to be in an off state, the supplementing on-off valve 430 is closed to enable the supplementing gas path 400 to be also in an off state, the oxygen sampling on-off valve 240 is opened, and the oxygen analyzer 220 detects the oxygen concentration of the exhaust flowing in the oxygen analyzer 220.

Specifically, both the purge gas and the supplemented inert gas may be purity nitrogen (PN2), and a purity nitrogen source of the plant system may be used as the gas source for the purging gas path 300 and the gas source for the supplementing gas path 400 at the same time. Preferably, a communicated position between the supplementing pipe 410 and the purging pipe 310 may be located between the purging pressure gauge 330 and the purging throttle valve 340.

In the present embodiment, the supplementing on-off valve 430 may be a normally open pneumatic valve. When the supplementing on-off valve 430 operates normally, the supplementing on-off valve 430 may be at a communicating position or a blocking position by controlling on and off thereof, so as to correspondingly control on and off of the supplementing pipe 410; when the supplementing on-off valve 430 fails, the supplementing on-off valve 430 may remain normally open to enable the supplementing pipe 410 to be in a communicated state, so that the supplementing gas source may introduce the inert gas into the oxygen analyzer 220 through the supplementing pipe 410, which ensures that the inert gas can expel oxygen from the oxygen analyzer 220 and protect the oxygen analyzer 220, and reduces the occurrence of the situations that there is residual oxygen in the oxygen analyzer 220 and the oxygen analyzer 220 is damaged due to drying pumping when the supplementing gas path 400 is off due to the failure of the supplementing on-off valve 430.

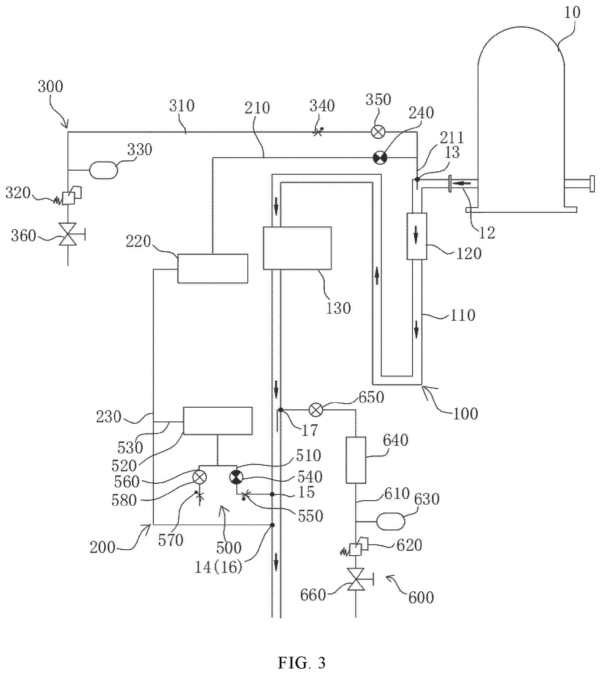

In some embodiments, as shown in FIG. 3, the exhaust discharge apparatus further includes a first hydrogen detection gas path 500 and a hydrogen dilution gas path 600, a gas inlet end of the first hydrogen detection gas path 500 is communicated with a third position 15 of the discharging gas path 100, a gas outlet end of the first hydrogen detection gas path 500 is communicated with a fourth position 16 of the discharging gas path 100, and the third position 15 is upstream of the fourth position 16 and the second position 14; and a gas outlet end of the hydrogen dilution gas path 600 is communicated with a fifth position 17 of the discharging gas path 100, and the fifth position 17 is upstream of the third position 15. The annealing process is performed after the inert atmosphere preparation process, an annealing gas containing hydrogen is introduced into the reaction chamber 10, hydrogen can perform a reduction protection function in the annealing process, the unconsumed hydrogen in the reaction chamber 10 enters the discharging gas path 100 as the exhaust, the first hydrogen detection gas path 500 is controlled to be in an operating state, the exhaust in the discharging gas path 100 may enter the first hydrogen detection gas path 500 through a communicated position at the third position 15, flow back into the discharging gas path 100 through a communicated position at the fourth position 16 of the discharging gas path 100 after being subjected to hydrogen concentration detection, a hydrogen concentration of the exhaust may be obtained by the first hydrogen detection gas path 500, and when the hydrogen concentration is lower than a safe concentration value, which indicates that the hydrogen concentration of the exhaust is relatively low at this time, there are no risks such as explosion, and the exhaust may be directly discharged to the plant system.

When the hydrogen concentration is higher than a safety standard, which indicates that the dangerous situations such as explosion may occur if the exhaust is discharged to the plant system through the discharging gas path 100 at this time, the hydrogen dilution gas path 600 needs to be operated to perform hydrogen dilution on the exhaust in the discharging gas path 100. Specifically, the hydrogen dilution gas path 600 is connected to a dilution gas source of the plant system, the dilution gas source introduces a dilution gas through the hydrogen dilution gas path 600 into the discharging gas path 100 via a communicated position at the fifth position 17, the dilution gas and the exhaust in the discharging gas path 100 are mixed into a mixed gas which has a reduced hydrogen concentration, the mixed gas flows into the first hydrogen detection gas path 500 through the communicated position at the third position 15 to be subjected to hydrogen concentration detection, and a dilution degree of the exhaust in the discharging gas path 100 by the dilution gas is adjusted by adjusting a flow of the dilution gas in the hydrogen dilution gas path 600 until the hydrogen concentration detected by the first hydrogen detection gas path 500 is lower than the safety standard, thereby ensuring safety of discharging the exhaust.

Specifically, in the annealing process, a mixed gas of argon and hydrogen may be introduced into the reaction chamber 10; a general nitrogen (GN2) source in the plant system may be used as the dilution gas source, and accordingly, general nitrogen is used as the dilution gas to dilute hydrogen in the exhaust; and a range of a first hydrogen detector 520 may be 10%, and a safe concentration range of hydrogen in the discharging gas path 100 may be 1%.

Specifically, in the present embodiment, as shown in FIG. 3, the first hydrogen detection gas path 500 includes the first hydrogen detector 520, a gas inlet of the first hydrogen detector 520 is communicated with the third position 15 through a first hydrogen-detection gas inlet pipe 510, a gas outlet of the first hydrogen detector 520 is communicated with the fourth position 16 through a first hydrogen-detection gas outlet pipe 530, and the first hydrogen-detection gas inlet pipe 510 is provided with a first hydrogen sampling on-off valve 540 and a first hydrogen sampling throttle valve 550; and the gas inlet of the first hydrogen detector 520 is further communicated with a first air delivery pipe 560, and the first air delivery pipe 560 is provided with a first air delivery throttle valve 570 and a first air delivery on-off valve 580. What is described here is one of the specific forms of the first hydrogen detection gas path 500. When the first hydrogen detection gas path operates, the first hydrogen sampling on-off valve 540 is opened to enable the first hydrogen-detection gas inlet pipe 510 to be in a communicated state, and the exhaust in the discharging gas path 100 may flow into the first hydrogen-detection gas inlet pipe 510 through a communicated position at the third position 15, and then flow into the first hydrogen detector 520 through the gas inlet, and the flow of the exhaust is adjusted by the first hydrogen sampling throttle valve 550; meanwhile, a gas inlet end of the first air delivery pipe 560 is communicated with an air source, the first air delivery on-off valve 580 is opened, the first air delivery pipe 560 is in a communicated state, the air source introduces the air into the first hydrogen detector 520 through the first air delivery pipe 560, and a flow of the introduced air is adjusted by the first air delivery throttle valve 570; and the first hydrogen detector 520 detects the hydrogen concentration of the exhaust based on the air and the exhaust which simultaneously enters the first hydrogen detector 520 to obtain the hydrogen concentration of the exhaust, the gas detected by the first hydrogen detector 520 flows into the first hydrogen-detection gas outlet pipe 530 through the gas outlet of the first hydrogen detector 520, then flows back into the discharging gas path 100 through a communicated position at the downstream fourth position 16, and is further discharged to the plant system. In this way, the first hydrogen detection gas path 500 achieves detection of the hydrogen concentration of the exhaust.

In some embodiments, as shown in FIG. 3, a first end of the first hydrogen-detection gas outlet pipe 530 is connected to the gas outlet of the first hydrogen detector 520, and a second end of the first hydrogen-detection gas outlet pipe 530 is connected to the gas outlet path of the oxygen detection gas path 200, and is communicated with the discharging gas path 100 through the gas outlet path. One pipe section of the gas outlet path of the oxygen detection gas path 200 close to the gas outlet end is used both for backflow delivery of the exhaust after oxygen detection and backflow delivery of the exhaust after hydrogen detection, and the second position 14 where the oxygen detection gas path 200 is communicated with the discharging gas path 100 and the fourth position 16 where the first hydrogen detection gas path 500 is communicated with the discharging gas path 100 are the same position. By using the single communicated position and the shared pipe section to realize the communication between the oxygen detection gas path 200 and the discharging gas path 100 and the communication between the first hydrogen detection gas path 500 and the discharging gas path 100, the set pipelines can be reduced, and the set communicated positions between the pipelines and discharging gas path 100 can also be reduced, which simplifies a structure of the exhaust discharge apparatus, improves air tightness of the exhaust discharge apparatus, and reduces assembly difficulty and cost. Specifically, the oxygen-detection gas outlet pipe 230 of the oxygen detection gas path 200 serves as the gas outlet path of the oxygen detection gas path 200 and is connected to the second end of the first hydrogen-detection gas outlet pipe 530.

Specifically, in the present embodiment, as shown in FIG. 3, the hydrogen dilution gas path 600 includes a dilution pipe 610, and a gas outlet end of the dilution pipe 610 is communicated with the fifth position 17; and a dilution pressure control valve 620, a dilution pressure gauge 630, a dilution flowmeter 640, and a dilution on-off valve 650 are sequentially disposed on the dilution pipe 610 along a gas delivery direction. In an example, the dilution pressure control valve 620 and the dilution pressure gauge 630 may be disposed in an upstream section of the dilution pipe 610 (i.e., a section close to a gas inlet end of the dilution pipe 610), and the dilution flowmeter 640 and the dilution on-off valve 650 may be disposed in a downstream section of the dilution pipe 610 (i.e., a section close to the gas outlet end of the dilution pipe 610). What is described here is one of the specific forms of the hydrogen dilution gas path 600.When hydrogen dilution does not need to be performed, the dilution on-off valve 650 is closed, and the hydrogen dilution gas path 600 is in an off state; and when hydrogen dilution needs to be performed , the dilution pipe 610 is connected to the dilution gas source, the dilution on-off valve 650 is opened, the dilution pipe 610 is in a communicated state, a pressure of the dilution gas introduced into the dilution pipe 610 by the dilution gas source is adjusted by the dilution pressure control valve 620, the dilution pressure gauge 630 may display the pressure of the dilution gas in the corresponding section, and a flow at which the dilution gas is to be introduced into the discharging gas path 100 is adjusted by the dilution flowmeter 640, so as to reduce consumption of the dilution gas while achieving dilution of hydrogen in the exhaust in the discharging gas path 100 with the dilution gas. Preferably, the gas outlet end of the dilution pipe 610 extends into the discharging gas path 100, and an orientation of a port of the gas outlet end is the same as a flow direction of the discharging gas path 100 at the fifth position 17, so as to ensure that a flow direction of the dilution gas when flowing into the discharging gas path 100 is the same as the flow direction of the exhaust, thereby reducing disturbance to the exhaust by the introduction of the dilution gas.

Specifically, in the present embodiment, the dilution on-off valve 650 may be a normally open pneumatic valve. When the dilution on-off valve 650 operates normally, the dilution on-off valve 650 may be at a communicating position or a blocking position by controlling on and off thereof, so as to correspondingly control on and off of the dilution pipe 610; and when the dilution on-off valve 650 fails, the dilution on-off valve 650 may remain normally open to enable the dilution pipe 610 to be in a communicated state, so that the dilution gas source may introduce the dilution gas into the discharging gas path 100 through the dilution pipe 610, which ensures a dilution effect of the dilution gas on hydrogen in the exhaust when the dilution on-off valve 650 fails, and accordingly ensures the safety of discharging the exhaust.

In the present embodiment, as shown in FIG. 3, the dilution pipe 610 may be further provided with a second hand operated valve 660, which is upstream of the dilution pressure control valve 620. The second hand operated valve 660 is configured to manually control on and off of a most upstream section of the dilution pipe 610 to control the introduction of the dilution gas by the dilution gas source into the dilution pipe 610 at the source, and may cooperate with the dilution on-off valve 650 for performing a secondary on-off control function. In particular, when the dilution on-off valve 650 fails, on and off of the dilution pipe 610 may be controlled by the second hand operated valve 660 to ensure normal use of the hydrogen dilution gas path 600, so as to improve stability and functionality of the hydrogen dilution gas path 600.

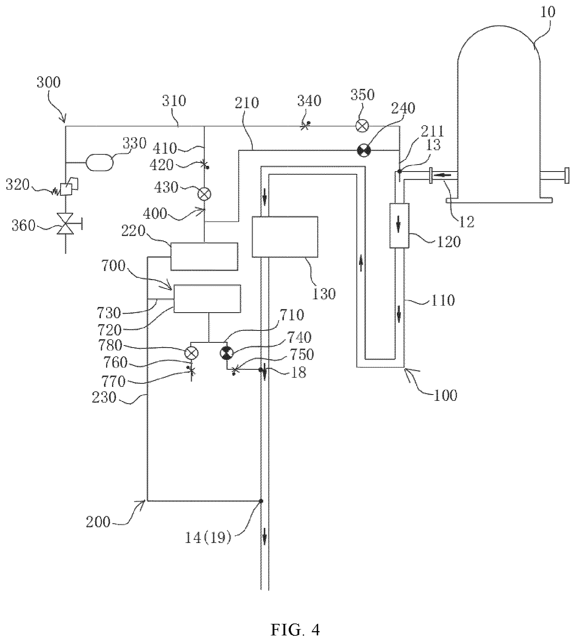

In some embodiments, as shown in FIG. 4, the exhaust discharge apparatus further includes a second hydrogen detection gas path 700, a gas inlet end of the second hydrogen detection gas path 700 is communicated with a sixth position 18 of the discharging gas path 100, a gas outlet end of the second hydrogen detection gas path 700 is communicated with a seventh position 19 of the discharging gas path 100, and the sixth position 18 is upstream of the seventh position 19 and the second position 14. After the annealing process is completed, the introduction of the annealing gas containing hydrogen into the reaction chamber 10 is stopped, an inert gas is introduced into the reaction chamber 10 to replace hydrogen in the reaction chamber 10, the exhaust flows into the second hydrogen detection gas path 700 through a communicated position at the sixth position 18 of the discharging gas path 100, and flows back into the discharging gas path 100 through a communicated position at the seventh position 19 after being subjected to hydrogen concentration detection, and when a hydrogen concentration detected by the second hydrogen detection gas path 700 is lower than a safety standard value, which indicates that the hydrogen concentration of the reaction chamber 10 reaches the safe concentration value at this time, the reaction chamber 10 may perform a chamber door opening operation for the wafer to be taken out from the reaction chamber 10; and when the hydrogen concentration detected by the second hydrogen detection gas path 700 is higher than the safe concentration value, which indicates that the hydrogen concentration of the reaction chamber 10 is relative high at this time, the introduction of the inert gas into the reaction chamber 10 needs to be continued to further expel and replace hydrogen until the hydrogen concentration is lower than the safe concentration value. Thus, with the second hydrogen detection gas path 700, whether the hydrogen concentration of the reaction chamber 10 meets the standard can be determined by detection, so that safety of use of the semiconductor thermal treatment equipment can be improved.

The second hydrogen detection gas path 700 may adopt a form similar to that of the first hydrogen detection gas path 500. Specifically, as shown in FIG. 4, the second hydrogen detection gas path 700 includes a second hydrogen detector 720, a gas inlet of the second hydrogen detector 720 is communicated with the sixth position 18 through a second hydrogen-detection gas inlet pipe 710, a gas outlet of the second hydrogen detector 720 is communicated with the seventh position 19 through a second hydrogen-detection gas outlet pipe 730, and the second hydrogen-detection gas inlet pipe 710 is provided with a second hydrogen sampling on-off valve 740 and a second hydrogen sampling throttle valve 750; and the gas inlet of the second hydrogen detector 720 is further communicated with a second air delivery pipe 760, and the second air delivery pipe 760 is provided with a second air delivery throttle valve 770 and a second air delivery on-off valve 780. A principle of use of the second hydrogen detection gas path 700 is the same as that of the first hydrogen detection gas path 500, and thus will not be repeated here. In addition, since the gas in the reaction chamber 10 is directly discharged to the surrounding environment when the chamber door opening operation is performed based on the gas in the reaction chamber 10, the safety standard value for the hydrogen concentration in the reaction chamber 10 is lower at this time, and accordingly, a range of the second hydrogen detector 720 is smaller than that of the first hydrogen detector 520. Specifically, the range of the second hydrogen detector 720 may be 1800 ppm, and the safe concentration value of hydrogen in the reaction chamber 10 may be 10 ppm.

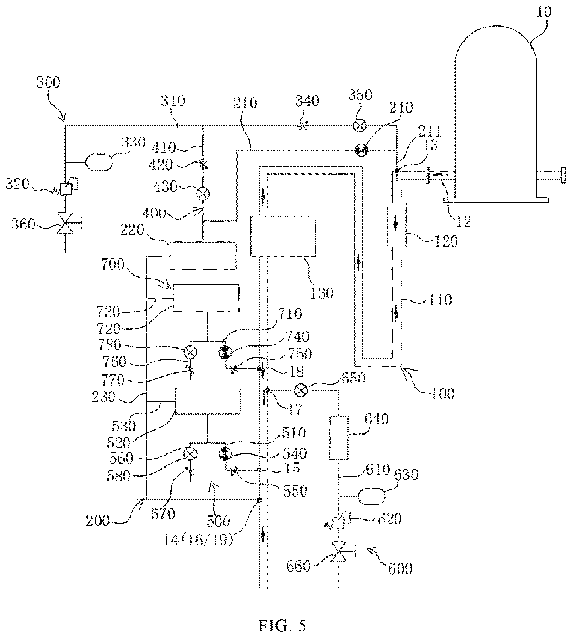

As shown in FIG. 5, similarly to the case where the gas outlet end of the first hydrogen-detection gas outlet pipe 530 is connected to the oxygen-detection gas outlet pipe 230, a gas outlet end of the second hydrogen-detection gas outlet pipe 730 may also be connected to the oxygen-detection gas outlet pipe 230, and communicated with the discharging gas path 100 through the oxygen-detection gas outlet pipe 230. Then, with the above arrangement, a pipe section of the oxygen detection gas path 200 close to the gas outlet end is simultaneously used for exhaust delivery for the oxygen detection gas path 200, the first hydrogen detection gas path 500, and the second hydrogen detection gas path 700, and the seventh position 19, the second position 14, and the fourth position 16 are the same position, which further reduces the set pipelines and the set communicated positions between the pipelines and the discharging gas path 100, thereby further simplifying the structure of the exhaust discharge apparatus, improving the air tightness of the exhaust discharge apparatus, and reducing the assembly difficulty and cost.

Specifically, in the present embodiment, as shown in FIG. 1 to FIG. 5, the discharging gas path 100 may include an exhaust pipe 110, a cooling assembly 120 and a discharging pressure control valve 130 are sequentially disposed on the exhaust pipe 110 along a flow direction of the exhaust pipe 110, the first position 13 is upstream of the cooling assembly 120, and the second position 14 is downstream of the discharging pressure control valve 130. What is described here is one of the specific forms of the discharging gas path 100. The cooling assembly 120 is configured to cool the high-temperature exhaust and condense water vapor in the high-temperature exhaust into condensed water, and the discharging pressure control valve 130 is configured to maintain pressure stability in the reaction chamber 10; and a communicated position between the gas inlet end of the oxygen detection gas path 200 and the exhaust pipe 110 is upstream of the cooling assembly 120 and close to the reaction chamber 10, and the exhaust at the communicated position is not affected by the cooling assembly 120 and the discharging pressure control valve 130, which ensures high accuracy of the detection of the oxygen concentration in the exhaust, and accordingly ensures the processing quality of the wafer by the semiconductor thermal treatment equipment.

Specifically, as shown in FIG. 5, the third position 15 where the first hydrogen detection gas path 500 is communicated with the discharging gas path 100, the fifth position 17 where the hydrogen dilution gas path 600 is communicated with the discharging gas path 100, and the sixth position 18 where the second hydrogen detection gas path 700 is communicated with the discharging gas path 100 are all downstream of the discharging pressure control valve 130.

Finally, it should be further noted that the relational terms such as "first" and "second" herein are only used to distinguish one entity or operation from another entity or operation, and do not necessarily require or imply that such relationship or order actually exists between the entities or operations. Moreover, the terms "includes", "comprises" or any other variation thereof are intended to indicate a non-exclusive inclusion, so that a process, method, article, or equipment, which includes a series of elements, does not only include those listed elements but also include other elements which are not explicitly listed, or the elements inherent in such process, method, article, or equipment. If there are no more limitations, limiting an element by "including a..." does not exclude the existence of other identical elements in the process, method, article, or equipment which includes the element.

The above description of the disclosed embodiments is intended to enable those of ordinary skill in the art to implement or use the present disclosure. Various modifications to these embodiments are apparent to those of ordinary skill in the art, and the general principle defined herein may be implemented in other embodiments without departing from the spirit or scope of the present disclosure. Thus, the present disclosure is not limited to the embodiments described herein, but falls in the widest scope consistent with the principle and novel features disclosed herein.

## Claims

1. An exhaust discharge apparatus of a semiconductor thermal treatment equipment, comprising:
a discharging gas path, which is configured to discharge exhaust;
an oxygen detection gas path, which is communicated in parallel with the discharging gas path, wherein a gas inlet end of the oxygen detection gas path is communicated with a first position of the discharging gas path, a gas outlet end of the oxygen detection gas path is communicated with a second position of the discharging gas path, and the second position is downstream of the first position; and
a purging gas path, which has a gas outlet end communicated with an entrance section of a gas inlet path of the oxygen detection gas path.

2. The exhaust discharge apparatus of claim 1, wherein a gas inlet end of the entrance section extends into the discharging gas path, and an orientation of a port of the gas inlet end of the entrance section is the same as a flow direction of the discharging gas path at the first position.

3. The exhaust discharge apparatus of claim 1 or 2, wherein the oxygen detection gas path comprises an oxygen analyzer, a gas inlet of the oxygen analyzer is communicated with the first position through an oxygen-detection gas inlet pipe used as the gas inlet path, and a gas outlet of the oxygen analyzer is communicated with the second position through an oxygen-detection gas outlet pipe; and the oxygen-detection gas inlet pipe is provided with an oxygen sampling on-off valve.

4. The exhaust discharge apparatus of claim 1 or 2, wherein the purging gas path comprises a purging pipe, and a purging pressure control valve, a purging pressure gauge, a purging throttle valve, and a purging on-off valve are sequentially disposed on the purging pipe along a purging direction.

5. The exhaust discharge apparatus of claim 3, further comprising a supplementing gas path, which has a gas outlet end communicated with the gas inlet of the oxygen analyzer.

6. The exhaust discharge apparatus of claim 5, wherein the supplementing gas path comprises a supplementing pipe, a gas inlet end of the supplementing pipe is communicated with the purging gas path, and a gas outlet end of the supplementing pipe is communicated with the gas inlet of the oxygen analyzer; and the supplementing pipe is provided with a supplementing throttle valve and a supplementing on-off valve.

7. The exhaust discharge apparatus of claim 1 or 2, further comprising a first hydrogen detection gas path and a hydrogen dilution gas path, wherein a gas inlet end of the first hydrogen detection gas path is communicated with a third position of the discharging gas path, a gas outlet end of the first hydrogen detection gas path is communicated with a fourth position of the discharging gas path, and the third position is upstream of the fourth position and the second position; and
a gas outlet end of the hydrogen dilution gas path is communicated with a fifth position of the discharging gas path, and the fifth position is upstream of the third position.

8. The exhaust discharge apparatus of claim 7, wherein the first hydrogen detection gas path comprises a first hydrogen detector, a gas inlet of the first hydrogen detector is communicated with the third position through a first hydrogen-detection gas inlet pipe, a gas outlet of the first hydrogen detector is communicated with the fourth position through a first hydrogen-detection gas outlet pipe, and the first hydrogen-detection gas inlet pipe is provided with a first hydrogen sampling on-off valve and a first hydrogen sampling throttle valve; and
the gas inlet of the first hydrogen detector is further communicated with a first air delivery pipe, and the first air delivery pipe is provided with a first air delivery throttle valve and a first air delivery on-off valve.

9. The exhaust discharge apparatus of claim 8, wherein a first end of the first hydrogen-detection gas outlet pipe is connected to the gas outlet of the first hydrogen detector, and a second end of the first hydrogen-detection gas outlet pipe is connected to a gas outlet path of the oxygen detection gas path, and is communicated with the discharging gas path through the gas outlet path.

10. The exhaust discharge apparatus of claim 7, wherein the hydrogen dilution gas path comprises a dilution pipe, and a gas outlet end of the dilution pipe is communicated with the fifth position; and a dilution pressure control valve, a dilution pressure gauge, a dilution flowmeter, and a dilution on-off valve are sequentially disposed on the dilution pipe along a gas delivery direction.

11. The exhaust discharge apparatus of claim 1 or 2, further comprising a second hydrogen detection gas path, wherein a gas inlet end of the second hydrogen detection gas path is communicated with a sixth position of the discharging gas path, a gas outlet end of the second hydrogen detection gas path is communicated with a seventh position of the discharging gas path, and the sixth position is upstream of the seventh position and the second position.

12. A semiconductor thermal treatment equipment, comprising a reaction chamber and the exhaust discharge apparatus of any one of claims 1 to 11, wherein the exhaust discharge apparatus is connected to the reaction chamber.
